# EUROPÄISCHE PATENTSCHRIFT

(11) **EP 0 944 922 B1**
(45) Veröffentlichungstag und Bekanntmachung des Hinweises auf die Patenterteilung: **18.08.2004**
(21) Anmeldenummer: 97951116.9
(22) Anmeldetag: 11.12.1997
(51) Int. Cl.: H01L 23/498, H01L 21/60

(54) **Verfahren zur Herstellung eines Chip-Moduls**
Manufacture of a chip module
Mode de fabrication d'un module de puce

(30) Priorität: 11.12.1996 DE 19651566
(43) Veröffentlichungstag der Anmeldung: 29.09.1999
(73) Patentinhaber: Finn, David, 87629 Füssen-Weissensee (DE); Rietzler, Manfred, 87616 Marktoberdorf (DE)
(72) Erfinder: Finn, David, 87629 Füssen-Weissensee (DE); Rietzler, Manfred, 87616 Marktoberdorf (DE)
(74) Vertreter: Böck, Bernhard, Dipl.-Ing.
(86) Internationale Anmeldenummer: PCT/DE1997/002885
(87) Internationale Veröffentlichungsnummer: WO 1998/026453

(56) Entgegenhaltungen:
- EP-A- 0 207 853
- US-A- 5 155 068
- PATENT ABSTRACTS OF JAPAN vol. 012, no. 407 (E-675), 27.Oktober 1988 & JP 63 147352 A (NEC CORP), 20.Juni 1988,

## Beschreibung

Die vorliegende Erfindung betrifft ein Verfahren zur Herstellung eines Chip-Moduls gemäß dem Oberbegriff des Anspruchs 1.

Chip-Module mit einem auf einem Substrat angeordneten Chip werden grundsätzlich überall dort eingesetzt, wo es darauf ankommt, durch die gegenüber den Chipanschlußflächen wesentlich vergrößerten Anschlußleiter des Substrats eine erleichterte elektrische Kontaktierung des Chips zu ermöglichen. So werden derartige Chip-Module beispielsweise in Chipkarten eingesetzt und ermöglichen über die freiliegend auf der Kartenoberfläche angeordneten Anschlußleiter des Substrats eine "äußere Kontaktierung" des durch die Anordnung auf der Rückseite des Substrats im Innern der Chipkarte aufgenommenen Chips. Des weiteren werden derartige Chip-Module auch zum Aufbau sogenannter kontaktloser Chipkarten verwendet, bei denen die Anschlußleiter des Substrats zur erleichterten Kontaktierung mit einer im Innern des Kartenkörpers angeordneten Antennenspule dienen. Natürlich lassen sich derartige Chip-Module beispielsweise auch zum Aufbau einer sogenannten "Combi-Card" benutzen, bei der über das Substrat sowohl eine äußere Kontaktierung für einen kontaktbehafteten Zugriff auf den Kartenchip als auch eine innere Kontaktierung für einen kontaktlosen Zugriff auf den Chip über die Antennenspule ermöglicht wird.

Durch die Kombination eines Chips mit dem Substrat zur Ausbildung des Chip-Moduls entsteht ein im Vergleich zur Dicke des Chips bzw. zur Dicke des Substrats relativ dicker Verbund, der in einem hinsichtlich seiner äußeren Abmessungen festgelegten Kartenkörper untergebracht werden muß. Um sich durch die Unterbringung eines Chip-Moduls in einem Kartenkörper hinsichtlich der Möglichkeiten weiterer Bauteilinstallationen im Kartenkörper möglichst wenig einzuschränken, erweist es sich daher als wesentlich, das Chip-Modul so dünn wie möglich auszuführen.

Ein Nachteil der bekannten, relativ dick ausgeführten Chip-Module besteht darin, daß sie schon aufgrund ihrer relativ großen Dicke im Vergleich zum flexiblen Kartenkörper eine höhere Biegesteifigkeit aufweisen, so daß es bei einer im Alltagsbetrieb häufig auftretenden Biegebeanspruchung des Kartenkörpers, insbesondere bei Anordnung des Substrats in der Kartenoberfläche, wie es bei einer Kontaktkarte der Fall ist, zu hohen Beanspruchungen der Verbindung zwischen dem Chip-Modul und dem Kartenkörper bis hin zu einer Ablösung des Chip-Moduls vom Kartenkörper kommen kann.

Aus der US-A-5,155,068 ist ein Chip-Modul sowie ein Verfahren zur Herstellung eines Chip-Moduls bekannt, bei dem die Herstellung der Verbindung zwischen dem Chip und dem Substrat in zwei aufeinanderfolgenden Verfahrensschritten erfolgt, wobei zunächst die elektrische Kontaktierung der Kontakthöcker des Chips mit Anschlußflächen des Substrats und anschließend die mechanische Verbindung zwischen dem Chip und dem Chip-Substrat durch eine Einbettung des gesamten Chips in eine den Chip umgebende Kunstharzmasse durchgeführt wird. Aufgrund der Einbettung des Chips in die den Chip umgebende Kunstharzmasse ist es bei der nachfolgenden abrasiven Bearbeitung der Chiprückseite notwendig, neben dem Chipmaterial auch-das den Chip umgebende Material abrasiv abzutragen.

Auch die JP-A-63 147 352 aus 'Patent Abstracts of Japan' zeigt ein Verfahren zur Herstellung eines Chip-Moduls, bei dem die Verbindung zwischen dem Chip und dem Chip-Substrat in zwei Verfahrensschritten erfolgt und bei dem der Chip zur mechanischen Verbindung mit dem Chip-Substrat in eine Kunstharzmasse eingebettet wird.

Die EP-A-0 207 853 zeigt ein Verfahren, bei dem die Herstellung einer Mehrzahl von Chip-Modulen kontinuierlich unter Verwendung eines Filmträgers erfolgt.

Der vorliegenden Erfindung liegt die Aufgabe zugrunde, ein Verfahren zur Herstellung eines Chip-Moduls vorzuschlagen, das eine vereinfachte Herstellung einer Verbindung zwischen einem Chip und einem Chipsubstrat sowie eine effektivere Bearbeitung des Chips zur Reduzierung der Chipdicke ermöglicht.

Diese Aufgabe wird durch ein Verfahren mit den Merkmalen des Anspruchs 1 gelöst.

Bei dem erfindungsgemäßen Verfahren nach Anspruch 1 wird die Kontaktierung des bzw. der Chips auf dem Substrat derart durchgeführt, daß auf den Anschlußflächen des bzw. der Chips angeordnete Kontakthöcker in ein Verbindungsmaterial eingesetzt werden, das in Ausnehmungen des Substrats angeordnet ist. Hierdurch kann eine Verbindung realisiert werden, die auch höchsten Scherbeanspruchungen standhält, wie sie beispielsweise bei einer Schleifbearbeitung der Rückseite des Chips entstehen, da die durch die Einbettung der Kontakthöcker in das Verbindungsmaterial hergestellte Verbindung noch zusätzlich durch den Eingriff der Kontakthöcker in die Ausnehmungen des Substrats gesichert wird.

Vor der Kontaktierung der Anschlußflächen kann eine selektive Reinigung der zu kontaktierenden Anschlußflächen des Chips und/oder der Kontaktflächen des Substrats bzw. der gegebenenfalls jeweils darauf aufgebrachten Kontakthöcker oder Verbindungsmaterialoberfächen erfolgen.

Die Bearbeitung des bzw. der Chips kann durch einen Schleif- oder Läppvorgang erfolgen. Eine weitere Möglichkeit der Bearbeitung des Chips zur Erzielung eines Chip-Moduls mit reduzierter Dicke besteht in der Durchführung eines chemischen Ätzvorgangs auf der Rückseite des Chips.

Das zur Herstellung der Verbindung benötigte Verbindungsmaterial kann nach Art und Darreichungsform unterschiedlich beschaffen sein. So kann das Verbindungsmaterial vor dem Einsetzen der Kontakthöcker in die Ausnehmungen durch flächigen Auftrag auf die Oberfläche der Isolationsschicht und anschließendes Abziehen der Oberfläche in die Ausnehmungen eingebracht werden.

Auch besteht die Möglichkeit, das Verbindungsmaterial vor oder nach dem Einsetzen der Kontakthöcker in die Ausnehmungen in einem Dosierverfahren in flüssigem Zustand in die Ausnehmungen einzubringen.

Eine weitere Möglichkeit der Applikation des Verbindungsmaterials besteht darin, vor dem Einsetzen der Kontakthöcker das Verbindungsmaterial in stückiger Form, etwa als Blei/Zinn-Lotkugeln, in die Ausnehmungen einzubringen.

Auch kann das zur Herstellung des Chip-Moduls verwendete Substrat bereits soweit vorbereitet sein, daß die Kontakthöcker in Ausnehmungen eingesetzt werden, die im Bereich der Anschlußleiter bereits mit einem Verbindungsmaterialauftrag versehen sind. Hierdurch ist es möglich, das erfindungsgemäße Verfahren zur Herstellung eines Chip-Moduls auch ausgehend von bereits vom Substrathersteller entsprechend präparierten Substraten durchzuführen, wodurch eine besonders kostengünstige Durchführung des Verfahrens möglich wird.

Wenn die Verbindung zwischen dem Verbindungsmaterial und den Kontakthöckern bzw. dem Verbindungsmaterial und den Anschlußleitern unter Einwirkung von Druck und Temperatur erfolgt, ist sichergestellt, daß eine Verbindung zwischen dem Chip und dem Substrat geschaffen wird, bei dem die benachbarten Oberflächen von Chip und Substrat aneinander anliegen, wodurch sich bei entsprechender Bemessung der Verbindungsmaterialmenge eine zumindest teilweise Einbettung der Kontakthöcker das Verbindungsmaterial auch bei einem Verbindungsmaterial mit hoher Grenzflächenspannung ergibt.

Die Verbindung zwischen dem Verbindungsmaterial und den Kontakthökkern kann entsprechend dem an sich bekannten "Flip-Chip"-Verfahren erfolgen, bei dem der Chip mit seinen Kontakthöckern unter Temperatureinwirkung gegen das Verbindungsmaterial gedrückt wird. Hierbei erfolgt demnach die zur Herstellung der Verbindung notwendige Erwärmung des Verbindungsmaterials während des Plazierens.

Die Verbindung kann aber auch so erfolgen, daß erst nach erfolgter Plazierung eine Erwärmung des Verbindungsmaterials und eine Herstellung der Verbindung im sogenannten "Reflow-Verfahren" erfolgt.

Unabhängig vom Zeitpunkt der Wärmeeinbringung in das Verbindungsmaterial erweist es sich als besonders vorteilhaft, wenn die Einbringung der Wärme in das Verbindungsmaterial über die Anschlußleiter des Substrats erfolgt. Auf diese Art und Weise bleibt bei Herstellung der Verbindung der Chip im wesentlichen frei von thermischen Belastungen.

Weiterhin ist es vorteilhaft, wenn nach der Bearbeitung des Chips eine Funktionsprüfung des Chips erfolgt. Hierbei bilden die Anschlußleiter des Substrats die Prüfkontakte. Die Durchführung dieser elektrischen Prüfung, in der Regel eine Durchgangsprüfung, ermöglicht die Detektierung eines möglicherweise infolge der Bearbeitung des Chips oder der Verbindungsherstellung zwischen Chip und Substrat in der Funktion beeinträchtigten Chip-Moduls.

Nachfolgend wird das erfindungsgemäße Chip-Modul anhand eines Ausführungsbeispiels sowie eines Verfahrens zu dessen Herstellung unter Bezugnahme auf die Zeichnungen näher erläutert. Es zeigen:
- **Fig. 1**: ein Chip-Modul in perspektivischer Darstellung mit einem Chip und einem darauf angeordneten Substrat;
- **Fig. 2**: eine Seitenansicht des in **Fig. 1** dargestellten Chip-Moduls in vergrößerter Darstellung;
- **Fig. 3**: das in **Fig. 2** dargestellte Chip-Modul in einer vergrößerten Teildarstellung;
- **Fig. 4**: eine in der Darstellung **Fig. 3** entsprechende Darstellung unmittelbar vor der Verbindung des Chips mit dem Substrat zur Ausbildung des Chip-Moduls;
- **Fig. 5**: eine Vorrichtung zur kontinuierlichen Herstellung des in Fig. **1** dargestellten Chip-Moduls in einer Schemadarstellung;
- **Fig. 6**: ein Substratband mit einzelnen Substraten in einer Abschnittsdarstellung.

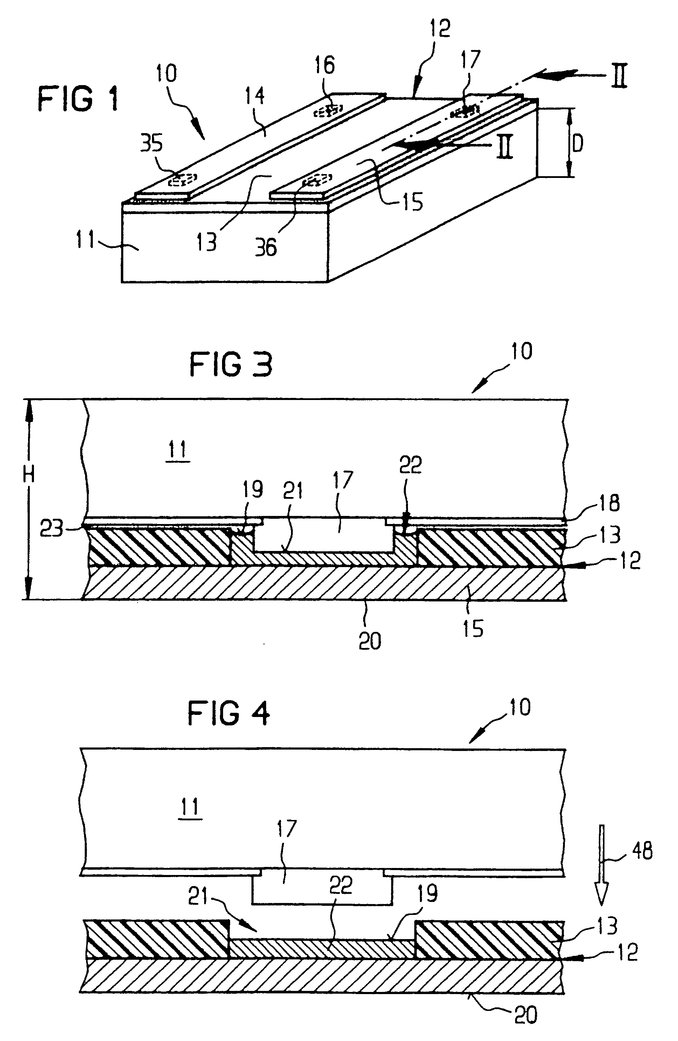

**Fig. 1** zeigt ein Chip-Modul 10 mit einem Chip 11 und einem darauf kontaktierten Substrat 12. Das Substrat 12 weist auf der dem Chip 11 abgewandten Oberseite einer hier als Trägerschicht 13 ausgebildeten Isolationsschicht Anschlußleiter 14, 15 auf, die bei dem hier dargestellten Beispiel in zweifacher Anzahl und sich im wesentlichen längs über die Trägerschicht 13 erstreckend auf dieser angeordnet sind.

Der Chip 1 weist bei dem in **Fig. 1** dargestellten Ausführungsbeispiel zwei in der Fachliteratur unter dem Begriff "Bump" bekannte erhöhte Kontaktmetallisierungen 16, 17 auf, die eine in **Fig. 1** nicht näher dargestellte Passivierungsschicht 18 (**Fig. 3**) des Chips 11 durchdringen und aus dieser hervorragen.

Obwohl **Fig. 1** einen lediglich mit zwei Kontaktmetallisierungen 16, 17 versehenen Chip 11 zeigt, wie er beispielsweise in eine hier nicht näher dargestellte Chipkarte eingesetzt wird, wird betont, daß die nachfolgenden Ausführungen ebenso Chips mit einer hiervon abweichenden Anzahl von Kontaktmetallisierungen, insbesondere solche mit einer Vielzahl von Kontaktmetallisierungen, betreffen, wobei in solchen Fällen auch das mit einem derartigen Chip zu verbindende Substrat in entsprechender Weise mit einer größeren Anzahl von Anschlußleitern ausgeführt ist. Die in **Fig. 1** dargestellte Ausführung wurde aufgrund der damit verbundenen besonders übersichtlichen Darstellungsmöglichkeit gewählt.

Bei dem in **Fig. 1** dargestellten Chip-Modul 10 weist der auf das Substrat 12 kontaktierte Chip 11 eine reguläre Dicke D auf, die im wesentlichen der Dicke eines hier nicht näher dargestellten Wafers entspricht, aus der der Chip 11 durch Herauslösung aus dem Waferverbund entstanden ist. Die in **Fig. 1** dargestellte Konfiguration des Chip-Moduls 10 bildet, wie nachfolgend noch näher erläutert wird, eine Handhabungseinheit als Ausgangsbasis zur Herstellung eines, hier in **Fig. 2** beispielhaft dargestellten Chip-Moduls 37 mit dem in seiner Dicke reduzierten Chip 38. Gegenüber dem in der **Fig. 1** dargestellten Chip 11 weist, wie durch die schraffierte Teilfläche in **Fig. 2** angedeutet werden soll, der Chip 38 nach einer materialabtragenden Bearbeitung einer den Kontaktmetallisierungen 16, 17 gegenüberliegenden, nachfolgend als Rückseite 39 bezeichneten Oberfläche eine um Δ d reduzierte Dicke auf, so daß die Dicke d des Chips 38 wesentlich geringer ist als die Dicke D des Chips 11 (**Fig. 1**).

Bei einem Vergleich der **Fig. 2** mit der **Fig. 3,** die das Chip-Modul 10 in einer vergrößerten Teilansicht zeigt, wird deutlich, daß durch die in **Fig. 2** dargestellte Dickenreduzierung Δ d gegenüber dem Chip-Modul 10 mit der Gesamtdicke H ein Chip-Modul 37 mit einer wesentlich geringeren Gesamtdicke h möglich wird.

Die **Fig. 3 und 4** verdeutlichen am Beispiel einer Verbindungsstelle die Art und Weise der Ausführung der Verbindung der Kontaktmetallisierung 17 mit dem Anschlußleiter 15 des Substrats 12 zur Herstellung des Chip-Moduls 10. Deutlich zu erkennen ist, wie die Kontaktmetallisierung 17 ausgehend von einer Überdeckungslage mit der zugeordneten Ausnehmung 19 in die in der Trägerschicht 13 im Bereich der Kontaktmetallisierung 17 ausgebildete Ausnehmung 19 eingreift. Die Ausnehmung 19 in der Trägerschicht 13 reicht bis zu dem auf der Rückseite der dem Chip 11 zugewandten Trägerschicht 13 angeordneten Anschlußleiter 15 und gibt diesen im Bereich eines gegenüberliegend einer Außenkontaktseite 20 angeordneten rückwärtigen Chipkontaktbereichs 21 frei.

In der Ausnehmung 19 befindet sich ein Verbindungsmaterial 22, das sowohl zur Herstellung einer elektrisch leitfähigen Verbindung zwischen der Kontaktmetallisierung 17 und dem Chipkontaktbereich 21 des Anschlußleiters 15 als auch zur Herstellung einer mechanisch sicheren Verbindung zwischen dem Chip 11 und dem Substrat 12 dient.

Bei dem in den **Fig. 3** und **4** dargestellten Verbindungsmaterial 22 handelt es sich um einen auf den Chipkontaktbereich 21 des Anschlußleiters 15 aufgebrachten Lotauftrag in fester Form. Die für den Lotauftrag gewählte Lotzusammensetzung ist dabei auf die für die Kontaktmetallisierung 17 verwendete Legierung bzw. Materialzusammensetzung abgestimmt. Im Falle der Verwendung von Gold für die Kontaktmetallisierung 17 bietet sich als Verbindungsmaterial ein Blei/Zinn-Lot an. Statt des Lotauftrags kann beispielsweise auch ein elektrisch leitender Kleber auf Epoxidharzbasis oder auch ein thermoplastischer Kleber Verwendung finden.

In jedem Fall wird unabhängig von der Beschaffenheit des Verbindungsmaterials die in **Fig. 3** dargestellte Verbindung zwischen der Kontaktmetallisierung 17 und dem Chip-Kontaktbereich 21 des Anschlußleiters 15 durch Einführen (Pfeil 48 in **Fig. 4**) der Kontaktmetallisierung 17 ausgehend von einer Anordnung des Chips 11 oberhalb des Substrats 12 (**Fig. 4**) in die Ausnehmung 19 unter Verdrängung des Verbindungsmaterials 22 ausgeführt. Um bei einer derart hergestellten Verbindung eine wiederholgenaue, gleichbleibende und möglichst geringe Gesamthöhe H des aus dem Chip 11 und dem Substrat 12 gebildeten Chip-Moduls 10 sicherzustellen, ist es ausreichend, die Kontaktmetallisierung 17 bis zur Anlage der Passivierungsschicht 18 des Chips 11 an der dem Chip 11 zugewandten Oberfläche der Trägerschicht 13 in die Ausnehmung 19 einzuführen. Um die über das Verbindungsmaterial 22 erfolgende, in **Fig. 1** am Beispiel der Kontaktmetallisierung 17 dargestellte mechanische Verbindung zwischen dem Chip 11 und dem Substrat 12 noch weiter zu verbessern, ist es möglich, wie in **Fig. 1** angedeutet, neben den Kontaktmetallisierungen 16, 17, die zur elektrischen Kontaktierung des Substrats 12 dienen, weitere Metallisierungsvorsprünge 35, 36 vorzusehen, die entsprechend den Kontaktmetallisierungen 16, 17 ausgebildet sind und in hier nicht näher dargestellte, in der Ausbildung den Ausnehmungen 19 entsprechende Befestigungsausnehmungen eingesetzt sind. Auch hier findet in identischer Weise, wie bei den Kontaktmetallisierungen 16, 17, eine Verbindung der Metallisierungsvorsprünge 35, 36 mit den Anschlußleitern 14, 15 statt, wobei diese Verbindung jedoch lediglich der mechanischen Sicherung des Chips auf dem Substrat dient und keine elektrische Kontaktfunktion hat. Zur Unterstützung der Haftung des Chips 11 auf dem Substrat 12 kann noch eine flächige oder periphere Verklebung des Chips 11 auf dem Substrat 12 vorgesehen werden.

Wie aus **Fig. 3** deutlich hervorgeht, bildet sich auch bei nur teilweiser Versenkung der Kontaktmetallisierung 17 in das Verbindungsmaterial 22 eine alle freiliegenden Seiten der hier vereinfacht als Quader dargestellten Kontaktmetallisierung 17 betreffende Benetzung aus. Hieraus resultieren entsprechend geringe elektrische Widerstände im Kontaktbereich der Kontaktmetallisierung 17 und des Verbindungsmaterials 22 sowie eine gute mechanische Haftung.

Um insbesondere bei starker Füllung der Ausnehmung 19 mit Verbindungsmaterial 22 die Ausbildung von Druckpolstern infolge von Kompressionseffekten in der Ausnehmung 19 zu verhindern, kann die Trägerschicht 13 des Substrats 12 auf ihrer dem Chip zugewandten Oberseite mit einem von der Ausnehmung 19 nach außen führenden rillenförmigen Entlüftungskanal 23 oder anderen geeigneten Einrichtungen versehen sein.

Neben der in **Fig. 1** dargestellten, als Trägerschicht 13 ausgebildeten Isolationsschicht kann auf den Anschlußleitern noch eine diese zumindest bis auf Kontaktausnehmungen abdeckende, weitere Isolationsschicht angeordnet sein. Darüber hinaus kann das Chip-Modul 10 auch mit einer auf dem Substrat angeordneten Spule zur Ausbildung eines Transponders versehen sein.

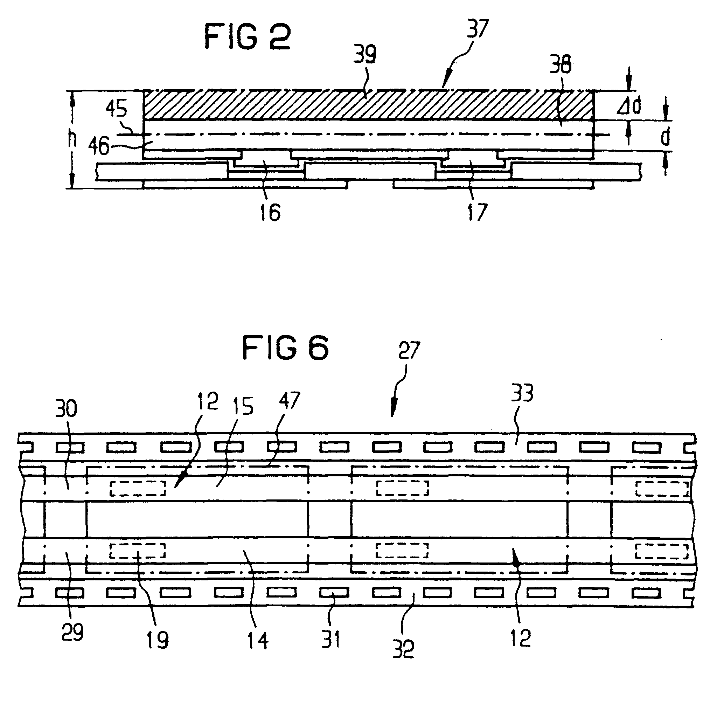

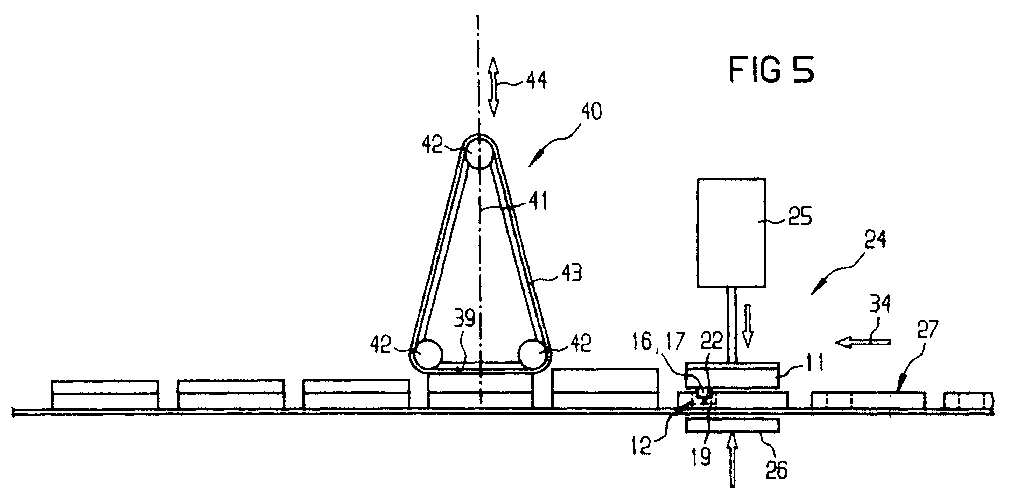

Die zum Versenken der Kontaktmetallisierung 17 in das Verbindungsmaterial 22 notwendige Erweichung des Verbindungsmaterials bzw. das Aufschmelzen des Verbindungsmaterials kann gleichzeitig mit Aufbringen des zum Verdrängen des Verbindungsmaterials notwendigen Drucks erfolgen, wie beispielsweise in **Fig. 5** dargestellt. **Fig. 5** zeigt eine Chip-Modul-Herstellungseinrichtung 24 mit zwei in einer stationären Einrichtung zusammengefaßten Komponenten, nämlich einer Chipplaziereinrichtung 25 und einer Heizeinrichtung 26. Wie **Fig. 5** zeigt, wird der Chip 11 von oben mit seinen nach unten gerichteten Kontaktmetallisierungen 16, 17 gegen das hier in einem Substratband 27 angeordnete Substrat 12 verfahren. Dabei werden die Kontaktmetallisierungen 16, 17 zur Anlage an das in den Ausnehmungen 19 auf dem Chipkontaktbereich 21 (**Fig. 3**) der Anschlußleiter 14, 15 angeordnete Verbindungsmaterial 22 gebracht. Während der Kontaktierung der Kontaktmetallisierungen 16, 17 mit dem Verbindungsmaterial 22 kann über die von unterhalb des Substratbands 27 gegen das betreffende Substrat 12 bewegte Heizeinrichtung 26 eine Kontaktbeheizung der Anschlußleiter 14, 15 erfolgen. Unter dem Druck der Chipplaziereinrichtung 25 dringen dann die Kontaktmetallisierungen 16, 17 in das unter der Temperatureinwirkung erweichende Verbindungsmaterial 22 ein.

Alternativ zu der vorstehend beschriebenen Erwärmung des Verbindungsmaterials 22 während der Plazierung des Chips 11, ist es auch möglich, das Verbindungsmaterial 22 nachfolgend der Plazierung der Chips 11 in einem Reflow-Verfahren aufzuschmelzen und hierdurch die für die Verbindung des Verbindungsmaterials 22 mit den Kontaktmetallisierungen 16, 17 notwendige Benetzung der Kontaktmetallisierungen zu bewirken. Je nach Beschaffenheit des Verbindungsmaterials kann es dabei notwendig sein, durch eine zusätzliche, der Chipplaziereinrichtung 25 nachgeordnete Druckeinrichtung durch Druck auf die Kontaktmetallisierungen 16, 17 den Grenzflächenwiderstand des Verbindungsmaterials 22 zu überwinden, um ein Versenken der Kontaktmetallisierungen 16, 17 im Verbindungsmaterial 22 zur Erzielung der beschriebenen Einbettung der Kontaktmetallisierungen 16, 17 im Verbindungsmaterial 22 zu ermöglichen.

**Fig. 6** zeigt das im Zusammenhang mit der in **Fig. 5** dargestellten Chip-Modul-Herstellungseinrichtung 24 bereits erwähnte Substratband 27 in einer Draufsicht. Wie die Draufsicht verdeutlicht, weist das Substratband 27 eine Vielzahl kontinuierlich aufeinanderfolgend ausgebildeter Substrate 12 auf, die über ihre substratübergreifend ausgebildeten Anschlußleiter 14, 15 miteinander verbunden sind. Zur Separierung eines einzelnen Substrats 11, wie es in **Fig. 1** dargestellt ist, aus dem Substratband 27 ist lediglich ein Stanzvorgang längs der strichpunktiert in Fig. 5 eingezeichneten Stanzlinien 47 notwendig. Durch den Stanzvorgang werden Verbindungsbereiche 29, 30 der Anschlußleiter 14, 15 sowie mit einer Perforation 31 versehene, als Traktionsränder ausgebildete Außenränder 32, 33 des Substratbands 27 abgetrennt. Eine derartige Ausbildung des Substratbands 27 ermöglicht eine kontinuierliche Fertigung von Chip-Modulen 10, wobei, wie in **Fig. 5** dargestellt, das Substratband 27 mit den darin vorgesehenen Substraten 12 in Vorschubrichtung 34 an der Chipplaziereinrichtung 25 getaktet vorbeigeführt wird.

Die in der Chip-Modul-Herstellungseinrichtung 24 hergestellten Chip-Module 10 bilden jeweils ein Zwischenprodukt bzw. eine Handhabungseinheit zur nachfolgenden Bearbeitung der Chips 11 mit dem Ziel, Chip-Module 37 mit im Vergleich zu den Chips 11 dünneren Chips 38 herzustellen. Durch den durch das Substratband gebildeten Verbund bilden die Chip-Module 10 in ihrer Gesamtheit einen entsprechenden Handhabungsverbund Vor der vorstehend erläuterten Separierung der Chip-Module 10 aus dem Substratband 27 erfolgt, wie in **Fig. 5** am Beispiel eines kontinuierlichen Herstellungsvorgangs dargestellt, eine materialabtragende Bearbeitung der Chips 11 der Chip-Module 10, nach deren Herstellung in der Chip-Modul-Herstellungseinrichtung 24. Hierzu werden die Chip-Module 10 einer Bearbeitungseinrichtung 40 zugeführt, in der ein Abtrag des Chipkörpermaterials von der Rückseite 39 des Chips 11 erfolgt, wie in **Fig. 2** schematisch dargestellt. Bei dem in **Fig. 5** beispielhaft dargestellten Bearbeitungsverfahren wird als Bearbeitungseinrichtung eine Bandschleifeinrichtung 40 verwendet, die ein auf einen Geräteträger 41 über Rollen 42 kontinuierlich umlaufendes, endloses Schleifband 43 aufweist. Der Geräteträger 41 ist mit einer hier nicht näher dargestellten Zustelleinrichtung versehen, die eine Auf- und Ab-Bewegung des Geräteträgers 41 in Richtung des Doppelpfeils 44 ermöglicht. Durch eine Überlagerung der umlaufenden Bewegung des Schleifbands 43 mit einer auf die Rückseite 39 des Chips 11 gerichteten Zustellbewegung ist es möglich, den Chip 11 kontinuierlich in seiner Dicke zu reduzieren, bis sich ein Chip 38 mit einer gegenüber dem ursprünglichen Chip 11 reduzierten Dicke d einstellt (**Fig. 2**). Die mittels dieser Bearbeitung erreichbare Dicke d ist begrenzt durch die in **Fig. 2** mit strichpunktiertem Linienverlauf angedeuteten Grenzschicht 45, die einen zwischen der Passivierungsschicht 18 und der Grenzschicht 45 liegenden Schaltungsbereich 46 des Chips begrenzt. Bis zum Erreichen der Grenzschicht 45 ist eine Bearbeitung des Chips von dessen Rückseite 39 her möglich, ohne durch ein Eindringen in den Schaltungsbereich 46 die Funktion des Chips zu beeinträchtigen.

Ergebnis der in **Fig. 5** dargestellten Bearbeitung des Chips 11 mit der Bandschleifeinrichtung 40 ist das in **Fig. 2** dargestellte Chip-Modul 37, das gegenüber dem Ausgangs-Chip-Modul 10 eine wesentlich verringerte Gesamthöhe h aufweist. Die kontinuierlich nach dem in **Fig. 5** dargestellten Verfahren hergestellten, in ihrer Dicke reduzierten Chip-Module 37 können dann wie vorstehend unter Bezugnahme auf die **Fig. 6** beschrieben, aus dem Verbund des Substratbands 27 separiert werden.

## Patentansprüche

1. Verfahren zur Herstellung eines Chip-Moduls mit einem Substrat und mindestens einem auf dem Substrat angeordneten Chip,
**dadurch gekennzeichnet,**
**dass** zur Herstellung einer elektrischen und mechanisch stabilisierenden Verbindung des Chips mit dem Substrat eine Kontaktierung von auf einer Vorderseite des Chips angeordneten Kontakthöckern (16, 17) mit auf einer Rückseite einer Trägerschicht (13) des Substrats (12) angeordneten Anschlussleitern (14, 15) der Leiterbahnstruktur des Substrats erfolgt, derart, dass die Kontakthöcker bis zur Anlage der Vorderseite des Chips (38) gegen eine Chipkontaktseite der Trägerschicht in ein in Ausnehmungen (19) der Trägerschicht angeordnetes Verbindungsmaterial (22) eingesetzt werden, und nachfolgend eine Bearbeitung des Chips durch ein Materialabtragsverfahren auf seiner Rückseite erfolgt, wobei das Substrat zur Handhabung und Stabilisierung des Chips während der Bearbeitung dient.

2. Verfahren nach Anspruch 1,
**dadurch gekennzeichnet,**
**daß** die Bearbeitung des bzw. der Chips (11) durch einen Schleif- oder Läppvorgang erfolgt.

3. Verfahren nach Anspruch 1,
**dadurch gekennzeichnet,**
**daß** die Bearbeitung des bzw. der Chips (11) durch einen Ätzvorgang erfolgt.

4. Verfahren nach einem oder mehreren der Ansprüche 1 bis 3,
**dadurch gekennzeichnet,**
**daß** nach der Bearbeitung des Chips (11) eine Funktionsprüfung des Chips erfolgt.

## Claims

1. Process for the production of a chip module with a substrate and at least one chip arranged on the substrate, **characterised in that** in order to produce an electrical and mechanically stabilising connection of the chip with the substrate a contacting is effected between contact humps (16, 17) arranged on a front side of the chip and connecting leads (14, 15) of the conductor path structure of the substrate arranged on a rear side of a carrier layer (13) of the substrate (12), in such a way that the contact humps are inserted into a connecting material (22) arranged in recesses (19) of the carrier layer until the front side of the chip (38) bears against a chip contact side of the carrier layer, and following this the rear side of the chip is worked by means of a material abrasion process, wherein the substrate serves for purposes of handling and stabilising the chip during the working.

2. Process according to claim 1, **characterised in that** the working of the chip(s) (11) is effected by a grinding or lapping process.

3. Process according to claim 1, **characterised in that** the working of the chip(s) (11) is effected by an etching process.

4. Process according to one or more of claims 1 to 3, **characterised in that** after the processing of the chip (11) a functional testing of the chip is carried out.

## Revendications

1. Procédé de fabrication d'un module à puce comportant un substrat et au moins une puce disposée sur le substrat,
**caractérisé en ce que**
pour la fabrication d'une liaison électrique et mécaniquement stabilisatrice entre la puce et le substrat, on met en contact des bosses de contact (16, 17) disposées sur une face avant de la puce avec des conducteurs de liaison (14, 15) de la structure de pistes conductrices du substrat disposés sur une face arrière d'une couche porteuse (13) du substrat (12), de telle sorte que les bosses de contact sont mises en place, jusqu'à l'appui de la face avant de la puce (38) contre une face de contact de puce de la couche porteuse, dans un matériau de liaison (22) disposé dans des évidements (19) de la couche porteuse, et que l'on effectue ensuite un traitement de la puce sur sa face arrière par le biais d'un procédé d'enlèvement de matière, le substrat servant alors à la manipulation et à la stabilisation de la puce pendant le traitement.

2. Procédé selon la revendication 1,
**caractérisé en ce que**
le traitement de la ou des puce(s) (11) s'effectue par le biais d'un processus de polissage ou d'abrasion.

3. Procédé selon la revendication 1,
**caractérisé en ce que**
le traitement de la ou des puce(s) (11) s'effectue par le biais d'un processus d'attaque.

4. Procédé selon l'une ou plusieurs des revendications 1 à 3,
**caractérisé en ce qu'**
après le traitement de la puce (11), on effectue un contrôle du fonctionnement de la puce.
